# EUROPÄISCHE PATENTSCHRIFT

(11) **EP 2 606 512 B1**
(45) Veröffentlichungstag und Bekanntmachung des Hinweises auf die Patenterteilung: **17.12.2014**
(21) Anmeldenummer: 11824297.3
(22) Anmeldetag: 22.08.2011
(51) Int. Cl.: H01L 31/0525

(54) **ANLAGE ZUR ERZEUGUNG ELEKTRISCHER ENERGIE AUS SONNENENERGIE**
SYSTEM FOR THE GENERATION OF ELECTRICITY FROM SOLAR ENERGY
INSTALLATION POUR LA PRODUCTION D'ÉNERGIE ÉLECTRIQUE À PARTIR D'ÉNERGIE SOLAIRE

(30) Priorität: 20.08.2010 DE 102010035384; 18.11.2010 DE 102010051565; 08.04.2011 DE 102011016450
(43) Veröffentlichungstag der Anmeldung: 26.06.2013
(73) Patentinhaber: Solar Real Contact GmbH, 18055 Rostock (DE)
(72) Erfinder: KLEBER, Joachim, 65428 Rüsselsheim (DE)
(74) Vertreter: Baumbach, Friedrich
(86) Internationale Anmeldenummer: PCT/DE2011/001650
(87) Internationale Veröffentlichungsnummer: WO 2012/072058

(56) Entgegenhaltungen:
- DE-A1- 4 307 705
- DE-A1-102006 023 616
- JP-A- 59 097 457
- US-A1- 2003 221 717
- US-A1- 2010 037 931

## Beschreibung

Die Erfindung betrifft eine Anlage zur Erzeugung von elektrischer Energie und Erhöhung der Arbeitsleistung einer Photovoltaikzelle (PV-Zelle). Anwendungsgebiet der Erfindung ist das Gebiet der Solarenergiegewinnung.

In der Beschreibung werden folgende Abkürzungen verwendet:
- NOCT: Normal Operation Cell Temperature
- P dot Wafer: Positiv dotierte Wafer
- PECVD: Plasma-Enhanced Chemical Vapour Deposition (plasmaunterstützte chemische Gasphasenabscheidung)
- P/N: Positiv/Negativ-Übergang
- PV-Zelle: Photovoltaik-Zelle
- STC: Standart Test Conditions
- THG: Thermogenerator

Die photovoltaische Energieumwandlung, also die Umwandlung von Sonnenenergie in elektrische Energie, findet mit Hilfe von Solarzellen in Photovoltaikanlagen statt. Die Wirkungsweise einer solchen Zelle beruht auf dem hinreichend bekannten photovoltaischen Effekt. Dieser ist Stand der Technik und wird in zahlreichen Schriften beschrieben (z.B. DE 21 2009 000 025 U1, WO 2009/135238 A2). Bei Lichteinwirkung findet in der Zelle an dem Halbleiterübergang eine Ladungstrennung statt, die zu einem Ladungsungleichgewicht in der Zelle führt. Das dabei entstehende elektrische Spannungsgefälle kann zur Umwandlung der Strahlungsenergie in elektrische Energie genutzt werden.

Photovoltaik-Module weisen in der Regel eine Schicht aus Solar- bzw. Photovoltaikzellen auf, sowie eine auf der Sonnenseite der Photovoltaikzellen angeordnete transparente Folie und ein auf der Folie angeordnetes transparentes Sicherheitsglas. Auf der Rückseite der Photovoltaikzellen, d. h. auf der sonnenabgewandten Seite der Zellen ist üblicherweise ebenfalls eine transparente Folienschicht aufgebracht.

Der Wirkungsgrad einer Photovoltaikanlage, auch als Effizienz bezeichnet, ist das Verhältnis der von ihr erzeugten elektrischen Leistung und der eingestrahlten Sonnenenergie Das heißt, sie gibt an, wie viel der eingestrahlten Lichtmenge in nutzbare elektrische Energie umgewandelt wird.

Das Einsatzgebiet der Photovoltaikanlagen bringt es mit sich, dass diese sich auf Grund der Sonneneinstrahlung erwärmen. Die Leistung einer solchen Anlage ist aber stark temperaturabhängig. Höhere Zelltemperaturen führen zu niedrigeren Leistungen und damit zu einem schlechteren Wirkungsgrad.

Verluste der herkömmlichen elektrischen Umwandlung ergeben sich im Wesentlichen als Abwärme, die in Form von Konvektion und Strahlung abgeführt wird. Zudem entsteht Abwärme aus dem Spektrum des Sonnenlichts, das nicht von der herkömmlichen PV-Zelle umgewandelt wird.

Es gibt im Stand der Technik bereits Vorschläge, um diese Wärmeenergie teilweise zu nutzen. So ist aus DE 10 2008 009 477 A1 eine solarthermische Stromerzeugungseinrichtung bekannt, welche einen Absorber enthält, auf dem über verbindende Bauteile ganz oder teilweise Solarzellen angeordnet sein können. Dadurch ergibt sich eine doppelte Nutzbarkeit der Stromerzeugungseinrichtung. Neben der Stromerzeugung kann die Energiemenge, die nicht in Strom umgewandelt. wird, in Form von Wärmeenergie gespeichert werden. So wird die zur Energiegewinnung verwendbare Fläche besser ausgenutzt. Eine Erhöhung des Wirkungsgrades bei der Stromerzeugung sowie der spezifischen Leistung im Verhältnis zur Sonneneinstrahlung kann durch die beschriebene Anordnung jedoch nicht erreicht werden.

In der mit dieser Patentanmeldung beschriebenen Technik kann aber auch die Wärmeenergie genutzt werden, um elektrischen Strom herzustellen. Beide Elemente können auf verschiedene Weise miteinander verbunden werden.

DE 10 2006 023 616 A1 bezieht sich auf ein System zur Gewinnung von Sonnenenergie durch Nutzung des thermoelektrischen Effekts unter gleichzeitiger Speicherung der Restwärme.

In der DE 3735410 A1 wird eine Anordnung beschrieben, mittels derer Wärmeenergie durch ein Thermoelement und ein Peltierelement in elektrische Energie umgewandelt werden kann. Weiter wird offenbart, dass dieser Effekt durch die Verwendung von magnetischen Feldern verbessert werden kann.

US 2003/0221717 A1 offenbart ein Photovoltaiksystem, welches elektrisch leitend mit einem thermoelektrischen System verbunden ist, um dieses mit Strom zu speisen. Dem thermoelektrischen System kann ein Latentwärmespeicher nachgeordnet. sein. Eine Wärmeleitpaste im kontakt mit den Solarzellen ist nicht offenbart.

DE 10 2008 040 028 A1 kombiniert einzelne technische Komponenten zur Energiegewinnung im Rahmen einer Energiewandlungsanlage und des zugehörigen Verfahrens zur Gewinnung, Wandlung, Speicherung und Bereitstellung von Energie an Verbraucher. Dabei wird ein Photovoltaikelement zur direkten Energiegewinnung verwendet, welche dann einem Elektroakkumulator, dem elektrischen Verbraucher oder auch einem Peltierelement zugeführt wird.

Alle im Stand der Technik beschriebenen Anordnungen haben zum Nachteil, dass die Effizienz der Photovoltaikzellen im Verhältnis zu der in dieser vorliegenden Patentanmeldung beschriebenen Wirkungsweise sehr niedrig ist. Eine Erhöhung der Arbeitsleistung einer solchen Zelle konnte bislang nicht erreicht werden.

Nach dem Stand der Technik bewegt sich die Effizienz zwischen 5 bis 25 %. Im Bereich der Module ist mit Leistungseinbußen von ca. 3 % zu rechnen, so dass üblicherweise Wirkungsgrade von 2 bis 22 % erzielt werden. Bei der Beurteilung von Leistungsdaten von photovoltaischen Bauteilen sind Normenbedingungen, STC (Standard Test Conditions), die bei einer Umgebungstemperaturvon 25°C, AM 1,5 und 1000 W/m² liegen, vereinbart worden (Quelle: IEC 904-3 1989 Photovoltaic devices; EN 60904-3 1993)

Diese Werte können nur unter Laborbedingungen erreicht werden, so dass durch die Abweichungen, die sich in der Praxis/Natur ergeben, eine deutliche Arbeitsminderung zu verzeichnen ist. Bereits eine Erhöhung der Temperatur einer Photovoltaikanlage um 2°C senkt deren Effizienz um 1%.

Ziel der Erfindung ist es, ein wesentlich leistungsstärkeres Photovoltaik-Modul basierend auf einer neuartigen Zelle mit einem höheren Wirkungsgrad zur Verfügung zu stellen. Der Erfindung liegt die Aufgabe zugrunde, eine Temperaturstabilisierung der sonnenabgewandten Seite einer Photovoltaikzelle zu erreichen, die der normierten Temperatur unter Laborbedingungen entspricht, was die Leistungsminderung bei Temperaturanstieg verhindert. Darüber sollen die daraus resultierenden Wärmedifferenzen zur Erzeugung von elektrischer Energie genutzt werden, auch zu Zeiten, in denen kein photovoltaischer Effekt anliegt.

Gelöst wird diese Aufgabe erfindungsgemäß mit einer elektrischen Anlage, welche die Merkmale von Anspruch 1 aufweist. Bevorzugte und vorteilhafte Ausführungsform der erfindungsgemäßen elektrischen Anlage ist Gegenstand der Unteransprüche.

Die wesentliche Idee der Erfindung besteht darin, die bei der Sonneinstrahlung entstehende leistungsmindernde Wärme zu nutzen und in elektrische Energie umzuwandeln. Besonders daran ist, dass erfindungsgemäß die Solarzellen herunter gekühlt werden und somit jeweils dem Arbeitspunkt folgend als sogenannter kühlkörper" wirken. Dies ist nicht nur auf den Wegfall der solaren Strahlung beschränkt, sondern findet immer dann statt, wenn die Abstrahlfähigkeit der Zelle in der Lage ist, den Wärmestrom über das Peltierelement kühlend zu beeinflussen, also ebenfalls tagsüber.

Dadurch, dass an der sonnenabgewandten Seite der Photovoltaikzellen ein Modul angebracht ist, welches aus Peltierelementen und jeweils daran angeschlossene Latentwärmespeicher besteht und das von einer Isolationsschicht umgeben ist, wird die Temperatur auf der sonnenabgewandten Seite der Zelle normiert und der Wirkungsgrad der Photovoltaikzelle wird im Endeffekt erhöht. Dazu wird die Wärmeenergie in verschaltete Latentwärmespeicher verbracht und hier über die Einrichtung zur Erzeugung elektrischer Energie wieder entnommen.

Beim Beladen der Latentwärmespeicher wird dem Wärmestrom durch die vorgeschalteten Peltierelementen durch Ausnutzung des Seebeck-Effektes elektrische Energie entnommen.

Die gespeicherte Wärmeenergie wird mit Hilfe der an dem Wärmestrom der sich einstellenden Wärmedifferenzstrecken teilhabenden Peltierelemente in elektrischen Strom umgewandelt. Dieser elektrische Strom entsteht bei der Wärmeleitung über das Peltierelement in den Latentwärmespeicher sowie aus dem Latentwärmespeicher über das Peltierelement in die sich abkühlenden Umgebungsbauteile. Dabei ergibt sich eine Dimensionierung auf verschiedene Latenttemperaturen und Kapazitäten, wodurch ein Wärmestrom entsteht, welcher den Seebeckeffekt verursacht.

Die Rückseite der Zelle ist eben durch den Latenttemperaturwert und die Kapazität des Speichers in der Lage, die Abwärme der PV-Zelle Wandlung so abzufangen, dass sie selbst durchaus eine niedrigere Temperatur annehmen kann als die Latenttemperatur des Wärmespeichers. In einer bevorzugten Ausführungsform der Erfindung stehen die Solarzellen in direktem Kontakt mit dem Thermogenerator. Ein Arbeitsmedium zum Medienaustausch ist im Latentwärmespeicher nicht vorhanden. Erfindungsgemäß ist der Wärmestrom in den Grenzen der Parametrierung selbstregelnd dem Gesamtstrahlungsaufkommen folgend.

Somit stellt die Solarzelle selbst für den thermischen Kreislauf einen sogenannten (Strahlungs)kühlkörper dar, welcher selbstregelnd entsprechend dem naturgegebenen Strahlungsangebot arbeitet.

Vorzugsweise werden dabei die elektrischen Energiequellen (Photovoltaikzelle; Thermogenerator) an Oszillatorschwingkreise angeschlossen, und die Schwingkreise hinsichtlich des elektrischen Bedarfs elektronisch aufeinander abgestimmt (Phasenlage und Amplitude).

Zellausführungen dieser Bauart machen die Verwendung von Wechselrichtern wie bei derzeitigen üblichen Photovoltaikinstallationen obsolet. Die Energieübertragung kann durch die zeitlich harmonische Änderung der abgegebenen Energie kontaktfrei ausgeführt werden, was die Systemverluste (ohmsche Widerstände, Korrosion, Wildfrass) minimiert.

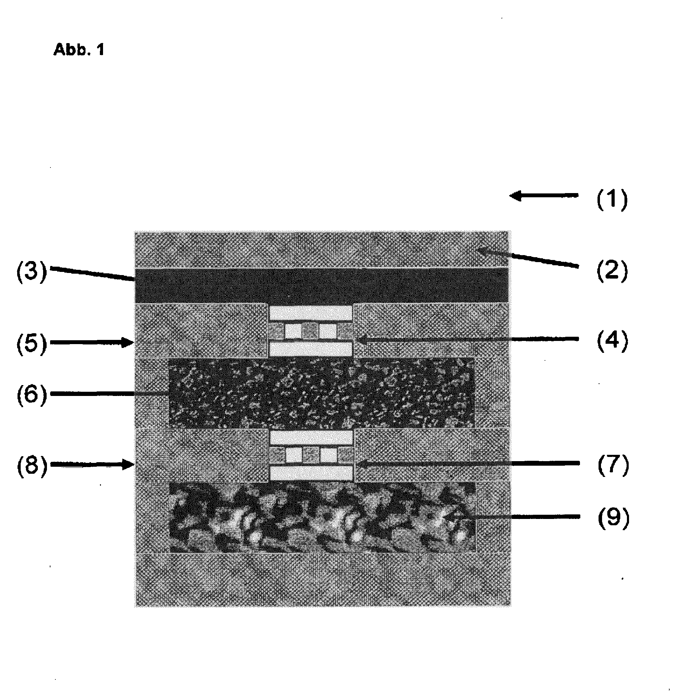

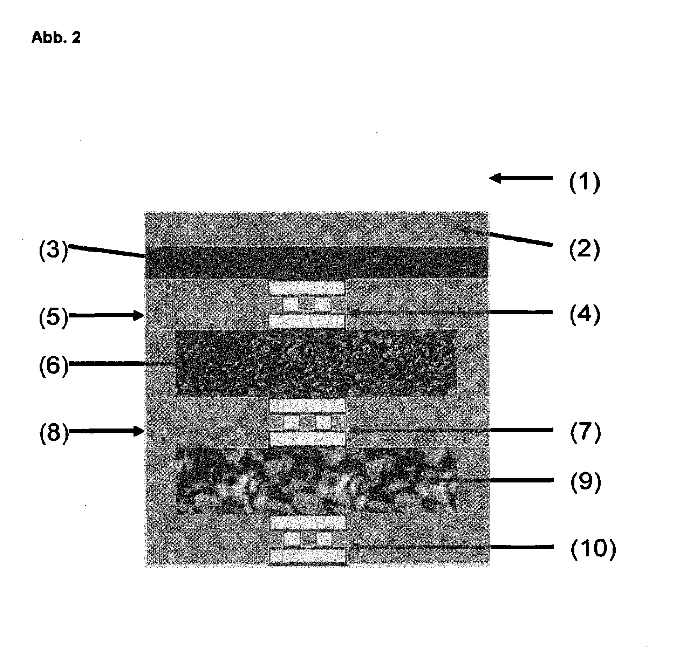

Die Erfindung wird anhand der Modulbeispiele aus Abb. 1 und Abb. 2 näher erläutert:

Aufbauend auf eine elektrische Anlage zur Erzeugung von Elektrizität aus solarer Strahlungsenergie bestehend aus einer Wetterschutzschicht (1), mechanischer Entkopplung und Schutzschicht (2) und der Photovoltaikzellschicht (3), ist über eine Wärmeleitpaste ein Modul bestehend aus einem Peltierelement (4), einer thermischen Isolationsschicht (5), einer nachgeordneten Stabilisierungsschicht mit Latentwärmespeicher (6) einem weiteren Peltierelement (7) mit Isolationsschicht (8) und der dazu dazugehörigen Stabilisierungsschicht mit einem oder mehreren Latentwärmespeichern installiert.

Im Unterschied zur geschlossenen Bauweise des Moduls aus Abbildung 1 enthält das Modul aus Abbildung 2 am Ende des letzten Latentwärmespeichers noch ein weiteres abschließendes Peltierelement (10), welches einen Durchgang zulässt.

Als Peltierelemente werden in diesem Beispiel Silizium-Peltiers verwendet, die mit den benachbarten Bauteilen über eine Wärmeleitpaste in Kontakt gebracht werden. Vorstellbar und nützlich für das Verständnis der Erfindung, aber nicht beansprucht, sind beispielsweise auch Peltierelemente, die direkt durch geeignete Stoffpaare auf die Zellrückseite der Zelle zum Beispiel mittels chemisch physikalischer Beschichtungstechnologie aufgebracht werden können (z.Bsp.PECVD). Jedes der Peltierelemente ist dabei mit einem Latentwärmespeicher verbunden.

Ferner besteht die Möglichkeit, die Peltierelemente mit den jeweils verbundenen Latentwärmespeichern kaskadenartig anzuordnen, die eine Steuerung der Wärmeeinlagerung, die Höhe der Temperaturunterschiede und die kontrollierte Wärmeabstrahlung und damit die kontrollierte Stromerzeugung während der Nacht ermöglicht. Hierbei muss allerdings die eventuell vorhandene Oszillatorschaltung der Temperatursteuerung nachgelagert werden.

Die in das Trägermaterial aus Gips, Zementgemischen oder Kunststoffe eingebetteten Latentwärmespeicher können je nach benötigtem Latentwärmepunkt Öle, Wassergemische und/oder Salze sein.

Polyurethanschäume werden in diesem Beispiel als Isolationsschicht verwendet. Denkbar sind aber auch Vakuumverkapselungen oder Inertgasverkapselungen.

Zur Optimierung der Energieinhalte der Latentwärmespeicher bezüglich der gespeicherten Energieniveaus und deren Entladung erfolgt für die oben beschriebenen Elemente eine äußere Beschaltung, die sowohl in der Fläche als auch bei den später beschriebenen Kaskaden die jeweils benötigten Energieniveaus dreidimensional einstellen können.

Beim Auftreffen von solarer Strahlungsenergie wandelt die Zelle diese Strahlung in elektrische Energie um. Dabei werden 5% bis ca. 25% in der Zelle in elektrische Energie umgewandelt. Je nach Effizienz der Zelle stehen 45-60% der ankommenden solaren Strahlung zur Verarbeitung hinter der Zelle in Form von Wärme zur Verfügung. Hierbei ist nicht die gesamt eingestrahlte Energie gemeint, sondern nur die Energie der Wellenlänge, für welche die Zelle ihre maximale Empfindlichkeit hat. Dies haben empirische Messreihen des Erfinders an handelsüblichen Modulen gezeigt.

Die Erfindung stellt nun im beispielhaft vorliegenden Fall (Abb.1 und 2) die Kombination Peltierelement (4), Isolationsschicht (5) und Latentwärmespeicher (6) auf ein Temperaturniveau im Latentwärmespeicher von 23°C ein und berücksichtigt eine Zelltemperaturänderung bei normaler Einstrahlung von ca. 38°C bis 79°C. Hierbei stellt sich ein variables Temperaturgefälle über das Peltierelement von 15°C bis 54°C ein. Die Leistung des Peltierelementes muss also bei 40-50K delta T gerade der Zellleistung entsprechen. Somit erzeugt das Peltierelement proportional zur Zellleistung die gleiche elektrische Leistung. Absolut verdoppelt sich die Gesamtleistung des Systems. Ist die Leistungskapazität des Latentwärmespeichers überschritten, erhöht sich dessen Temperatur, was zur Zerstörung führen könnte. Deshalb wird der Speicher (9) mit den angeschlossenen Teilen (7) und (8) 10K niedriger dimensioniert, so dass hier eine Schutzsenke entsteht.

Das Prinzip der Aufteilung der einzulagernden Wärme in die Latentwärmespeicher in den Kaskaden besteht demzufolge darin, dass bezogen auf die jeweils kalibrierten Latentwärmespeicher, überschießende Wärme in den jeweils nachgelagerten Latentwärmespeicher eingelagert wird.

Damit wird verhindert, dass der jeweilige Latentwärmespeicher seinen kalibrierten Temperaturbereich verlässt. Ferner besteht die Möglichkeit, Temperaturkaskaden aufzubauen.

Steht ein entsprechend großes Strahlungsangebot zur Verfügung, kann auch ein Speicher mit zum Beispiel 20K höherer Temperatur verwandt werden, sodass über das zwischen den Speichern liegende Peltierelement bei Beaufschlagung mit geringer elektrischer Energie der erste Speicher gekühlt und der zweite Speicher geladen wird. Je nach Bedarf können derartige Kaskaden aus Peltierelement und Latentwärmespeicher einen Wärmepfad bilden, der das Temperaturpotential derart über die Umgebungstemperatur hebt, dass am Ausgang eines derartigen Pfades ein abschließendes Peltierelement (Abb 2 [10]) den Generator des Gesamtsystems bildet.

Die Erfindung betrifft eine elektrische Anlage gemäß Anspruch 1.

In einer bevorzugten Ausführungsform ist die elektrische Anlage dadurch gekennzeichnet, dass der Latenttemperaturwert innerhalb der Anlage auf die jeweils durch die Speichermedien vorgegebenen Latentwärmepunkte ansteuerbar ist, so dass eine maximale elektrische Energiemenge generierbar ist und abgeführt werden kann.

In einer anderen bevorzugten Variante enthält die elektrische Anlage ein Modul welches aus einem Peltierelement oder aus Kaskaden von zwei oder mehr Peltierelementen besteht.

Dabei kann das Modul eine geschlossene oder eine offene Bauweise mit einem Peltierelement am Ende des letzten Wärmespeichers aufweisen.

Als Peltierelemente können Silizium-Peltiers oder Peltiers aus anderen Halbleiterwerkstoffen verwendet werden.

In einer besonders bevorzugten Ausführungsform werden die Peltierelemente mit den benachbarten Bauteilen über eine Wärmeleitpaste oder andere leitende Verbindungen in Kontakt gebracht.

Die Verwendung von Gips, Zementgemische oder Kunststoffe als Trägermaterial für die Latentwärmespeicher, in deren Vernetzungsebenen die Latentwärmespeicher eingelagert sind, hat sich ferner als vorteilhaft erwiesen.

Weiter bevorzugt sind Latentwärmespeicher, die je nach benötigtem Latentwärmepunkt aus Ölen, Wassergemischen und/oder Salzen bestehen.

In einer anderen bevorzugten Ausführungsform ist der erste Latentwärmespeicher mit dem angeschlossenen Peltierelement gegenüber dem zweiten Latentwärmespeicher unterschiedlich dimensioniert.

Eine weitere Ausführungsvariante ist dadurch gekennzeichnet, dass für die Peltierelemente mit den nachgeordneten Latentwärmespeichern eine äußere Beschaltung erfolgt.

Die Peltierelemente sind mit den jeweils nachgeordneten Latentwärmespeichern von einer Isolationsschicht umgeben. Als Isolationsschicht werden dabei besonders bevorzugt Polyurethanschäume, Inertgasverkapselungen oder Vakuumverkapselungen verwendet.

In einer weiteren Ausführungsform werden die Systeme aus einer Photovoltaikzelle einem Thermogenerator und einem Latentwärmespeicher ausgeführt, wobei der Thermogenerator von seiner Leistung bei NOCT gleichauf der Zellleistung der Photovoltaikzelle bemessen ist. Die Gesamtleistung der Anordnung gegenüber der Photovoltaikzelle alleine verdreifacht sich dadurch, das die PV-Zelle und die THG Leistung beim Einlagern der Wärme gleich bemessen ist, und beim Auslagern der Wärme aus dem Latentwärmespeicher der THG dieselbe Leistung erneut erbringt. Der Vorgang der Auslagerung erfolgt allerdings nicht nur bei Wegfall der solaren Einstrahlung, sondern zudem immer dann, wenn die Photovoltaikzelle ein größeres negatives Strahlungsangebot gegenüber diesem Arbeitspunkt aufweist, also gerade auch zu Zeiten an denen die Zelle nicht senkrecht bestrahlt wird, aber senkrecht zur Zelle eine große Temperatursenke zur Verfügung steht.

Hierbei dreht sich die Spannungsrichtung der elektrischen Spannung des THG um, was sich nachteilig auf die Energieverarbeitung auswirkt.

Deshalb ist es zweckmäßig, PV-Zelle und THG mit getrennten Oszillatorschwingkreisen zu versehen, damit die Richtung der erzeugten Gleichspannung immer für die Verbraucherseite positiv zur Verfügung stehen. Eine entsprechende Triggerschaltung bringt die beiden oszillierenden Energieströme elektronisch in Einklang, so dass am Ausgang der PV-Zelle THG Wärmespeicheranordnung immer eine dem aktuellen Strahlungsangebot maximale elektrische Wechselgrösse ansteht.

Diese Wechselgrösse lässt sich zu Modulgeometrien kombinieren, wobei der Verschaltung der so angeordneten Zellen im Idealfall berührungsfrei induktiv eine gemeinsame Modulspannungsführung eingekoppelt wird. Je nach benötigter Netzspannung können Zellen entsprechend seriell bzw. parallel kombiniert werden, somit bedarf es am Ausgang des Moduls nur einer Anpassung dieser Wechselspannung auf das vorhandene Netzniveau bzw. Verbraucherniveau. Aufwendige Lötstationen bei einer automatischen Modulfertigung können somit entfallen und mechanischer Stress der Zellen und damit einhergehender Ausfall durch Zellbruch wird minimiert.

Eine herkömmliche Wechselrichterschaltung ist zudem nicht mehr erforderlich.

Die Störungsanfälligkeit einer solchen Technologie reduziert sich somit um den Faktor Wechselrichter, die Kosten auch.

Beim Aufbau kaskadierter PV-Peltier-Latentwärmespeichergeometrien, bei denen das THG das am weitesten von der Strahlungsquelle entfernt platzierte ist, und mit der schattenbildenden Seite der Anordung mit der Umgebung als Temperatursenke arbeitet, dient das zweite THG als Energiequelle für die kumulierenden THG Stufen 3-(n-3) bis zum Erreichen der Latenttemperatur des letzten Speichers, und das letzte THG zur Erzeugung der thermoelektrischen Energie mit der Umgebung als Temperatursenke. Hierbei wird die entstehende elektrische Energie wie bei dem PV-Kreis und dem 1. THG Kreis analog zu dem oben beschriebenen Verfahren eingekoppelt.

### Ausführungsbeispiel 1

Im vorliegenden Beispiel steht die Senke mit dem zwischengeschalteten Peltierelement (7) als Kapazitätserweiterung des Latentwärmespeichers (6) zur Verfügung, um bei etwaig größerem Leistungsaufkommen an solarer Strahlungsenergie mehr latente Wärme einlagern zu können. Je nach Dimensionierung des Punktes der latenten Wärmespeicherung und der Ausgestaltung eventuell nachgeschalteter Kaskaden kann hiermit die Leistung gewonnen werden, die für die Sicherstellung bzw. eine Erhöhung der Grundleistung benötigt wird.

Im Falle der solaren Einstrahlung wird somit die Hälfte der Wärmeverluste elektrisch umgewandelt bzw. in Form von latenter Wärme eingelagert.

Im Falle des Wegfalls der solaren Einstrahlung erwärmt sich die Zelle (3) über das Peltierelement (4) und gibt diese Wärmeenergie in Form von Strahlung an die Umgebung ab. Theoretisch liegt hier die Temperatursenke für die Zelle bei einer Temperatur nahe dem absoluten Nullpunkt, vermindert durch Verluste (Reflexion, Streuung) der Atmosphäre, jedoch deutlich unterhalb der Temperatur, die durch gespeicherte Energie aus solarer Strahlung durch den Latentwärmespeicher nachgeliefert wird.

Die elektrische Energie des Peltierelementes (4) ist der des Peltierelementes (7) entgegengerichtet, so dass für diesen Fall eine geeignete Polumkehr am Ausgang des Peltierkreises (4) vorgehalten wird (Brückengleichrichtung, Oszillatoren).

Die Polarität des elektrischen Stromes des Peltierelementes (4) ist zu dem beschriebenen Zeitpunkt auch entgegengesetzt zu dem Strom desselben bei Ladung der Latentwärmespeicher.

Die elektrische Arbeit, die mit der Erfindung verrichtet wird, ist im beispielhaft gewählten Fall etwa dreimal so hoch wie die elektrische Arbeit, die ein handelsübliches Photovoltaiksystem bei gleicher Flächennutzung verrichten kann. Betrachtet man die reale solare Einstrahlung in Mittel- und Osteuropa im Jahresverlauf, so gewährleistet die latent eingelagerte Wärmeenergie des Speichers (6) und die permanent wärmetechnisch leitende Verbindung (4) zur Zelle (3), dass die Schichten oberhalb der Zelle gegenüber handelüblichen Aufbauten in Zeiten des Erreichens der Frostgrenze nicht mehr einfrieren können und der Aufbau von strahlungsunterbindenden Schneeschichten sicher unterbunden ist. Dies ermöglicht hinsichtlich des Jahresertrages zusätzliche Gewinne an elektrischer Arbeit ohne Anwendung zusätzlicher Energien, wie sie z. B. bei handelsüblichen Abtauschaltungen benötigt werden.

Statisch ist bei Konstruktionen etwa als Modul nur das tatsächliche Gewicht des Moduls zu berücksichtigen und keine kalkulativen regionalen Zuschläge, wie etwa Schneelasten, z. B. bei Ganzdacheindeckungen. Beispielhafte Aufbaumöglichkeiten der Module für eine Photovoltaikanlage sind in den Abbildungen 1 und 2 dargestellt.

### Nicht beanspruchte Variante

In einer nicht beanspruchten Variante ist der erste Peltierkreis mittels bekannter Prozessverfahren direkt auf die Rückseite einer Photovoltaik Zelle aufprozessiert. Hierfür sind die Prozessschritte heutiger Photovoltaik Zellen und standardisierte Materialien wie die Rückseitenkontaktierung der Photovoltaik Zelle verändert, damit der Herstellungsprozess des Peltierkreises keine Funktionsschichten der Photovoltaik Zelle oder die Photovoltaik Zelle selbst zerstört.

In einer Ausführungsform wird eine Photovoltaik Zelle bestehend aus P dot Wafer bei einer Temperatur größer 600 °C im Induktionsofen N dotiert. Im Anschluss hieran werden die Kanten isoliert, und nun wird auf die Vorderseite ein Silber (Ag) Gitter aufgebracht und auf die Rückseite eine leitende Silberschicht, die kein Gitter sein muss. Bisher werden diese leitenden Schichten am Ende der Vakuumschichten aufgebracht und durch Befeuern optimiert, was allerdings die Zellen einem hohen thermisch/ mechanischen Stress unterzieht.

Eine weitere Variante verwendet auf der Vorderseite der Zelle statt eines elektrisch leitenden Gitters eine transparent leitende Schicht aus Titanoxid oder Zinkoxid, Hierdurch kann auf die Metallisierung und bei geeignetem Fertigungsverfahren auf die Negativdotierung verzichtet werden, was eine Massenfertigung erheblich vergünstigt.

Nun kann die Vorder- und Rückseite in einem Niedrigtemperaturvakuumbeschichtungsverfahren beidseitig mit einer Siliziumnitridschicht beschichtet werden, wodurch auf der Vorderseite eine Antireflexschicht entsteht, die neben dem vorteilhaften Absorptionsverhalten elektrisch isolierend und aufgrund des Absorptionsgesetzes (A=R) thermisch gut leitfähig ist.

Auf der Rückseite ergibt sich so eine Fläche, auf der erneut eine elektrisch leitende Schicht zum Beispiel im Vakuumverfahren abgeschieden werden kann, die wenn sie entsprechend der Geometrie des erforderlichen Peltierkreises maskiert ist, die elektrisch leitenden Verbindungen der P/N Schenkel des Peltierkreises darstellen. Werden nun die erforderlichen Schenkel entsprechend aufgebracht und an den offenen Seiten elektrisch leitend verbunden, entsteht eine Photovoltaikzelle mit einem rückseitigen Peltierkreis, als ein funktionelles Bauteil der beschriebenen Erfindung.

Bei diesem nicht beanspruchten Beispiel gibt es naturgegeben kein Erfordernis nach einer thermisch leitenden Paste zwischen PV-Zelle und Peltierkreis.

Für den einfachsten Fall der beschriebenen Erfindung bedarf es nun einer rückseitigen Einkapselung eines Latentmaterials dieses neuartigen Bauteils mit einem dreiseitig gut thermisch isolierten Bauteil der entsprechenden elektronischen Schwingkreise für die beiden Spannungsquellen, und die Erfindung erfüllt die beschriebenen Eigenschaften.

Durch die Erfindung wird eine wesentliche Verbesserung des Wirkungsgrads einer Photovoltaikanlage erzielt. Diese Verbesserung basiert auf folgenden Umständen:
1. Die Leistungsabgabe der Photovoltaikzelle nähert sich der angegebenen Nennleistung, da die Randbedingungen der Nennleistung hinsichtlich der Bauteiltemperatur erfüllt sind.
2. Der durch die Stabilisierung entstehende Wärmestrom und die mit der Erfindung realisierte Umsetzung in elektrische Energie erhöht die Gesamtleistung.
3. Die Arbeitsleistung steigt zudem dadurch, dass bei Wegfall der solaren Einstrahlung die zuvor gespeicherte Wärme bei ihrem Rückfluss von Latentwärmespeicher zur Zelle über das beteiligte Peltierelement in elektrische Energie umgewandelt wird.
4. Bei der Anwendung von Kaskaden von Peltierelementen und Latentwärmespeichern zur Erhöhung der Latentspeichertemperaturen wird die elektrische Energieabgabe des Systems, bezüglich der Zeit und der abgegebenen Leistung steuerbar.
5. Die Umsetzung von solarer Strahlung in elektrische Energie ist nicht mehr nur auf die diskreten Wellenlängenbereiche der photovoltaisch wirksamen Stoffpaarung beschränkt, sondern nutzt den gesamt in Wärme umsetzbaren Strahlungsbereich. In Zeiten geringer solarer Wärmeeinstrahlung dient die solare Lichteinstrahlung bei gleichem Flächenverbrauch zur Grunddimensionierung. Auftretende Wärme in Zeiten hoher solarer Lichteinstrahlung wirkt nicht mehr elektrisch leistungsmindernd.

Die somit durchgängige und ohne Unterbrechung erzeugte elektrische Energie führt zu einer Stabilisierung der Stromversorgung und ist geeignet für eine Grundlastversorgung. Sie kann in der Vernetzung für die Entwicklung von dezentralen Energieversorgungen verwendet werden, aber auch zur Stabilisierung herkömmlicher Verbrauchernetze hinsichtlich der Bereitstellung der Energie zur Abdeckung der benötigten Grundlastversorgung und Erhöhung des ökologischen Anteils.

### Legende zur Abbildung

**Abbildung 1****:** Modul für eine Photovoltaikanlage zur Erhöhung der Arbeitsleistung mit geschlossener Bauweise.
   Wetterschutzschicht (1)
   mechanische Entkopplung und Schutzschicht (2) der Zelle Photovoltaikzellschicht (3)
   Installation eines Peltierelements (4)
   thermische Isolationsschicht (5)
   Stabilisierungsschicht mit Latentwärmespeicher (6) Peltierelement (7)
   Isolierung (8)
   Trägermaterial mit Latentwärmespeicher (9)
**Abbildung 2****:** Modul für eine Photovoltaikanlage zur Erhöhung der Arbeitsleistung mit offener Bauweise.
   Wetterschutzschicht (1)
   mechanische Entkopplung und Schutzschicht (2) der Zelle
   Photovoltaikzellschicht (3)
   Installation eines Peltierelements (4)
   thermische Isolationsschicht (5)
   Stabilisierungsschicht mit Latentwärmespeicher (6)
   Peltierelement (7)
   Isolierung (8)
   Trägermaterial mit Latentwärmespeicher (9)
   abschließendes Peltierelement eines Wärmepfades (10)

## Patentansprüche

1. Elektrische Anlage mit einer Schicht aus Solarzellen und einer auf einer dem Tageslicht zugewandten Seite befindlichen Wetterschutzschicht (1),
wobei an der Rückseite der Schicht aus Solarzellen (3) ein Modul aus mindestens einem Peltierelement (4, 7) und jeweils nachgeordnetem Latentwärmespeicher (6, 9), die von einer thermischen Isolationsschicht umgeben sind (5), angeordnet ist und dass das Modul mit der Schicht aus Solarzellen (3) über eine Wärmeleitpaste in Kontakt gebracht ist.

2. Elektrische Anlage nach Anspruch 1, **dadurch gekennzeichnet, dass** der Latenttemperaturwert innerhalb der Anlage auf die jeweils durch die Speichermedien vorgegebenen Latentwärmepunkte ansteuerbar ist, so dass eine maximale elektrische Energiemenge generierbar und abführbar ist.

3. Elektrische Anlage nach Anspruch 1-2, **dadurch gekennzeichnet, dass** das Modul aus Kaskaden von zwei oder mehr Peltierelementen und jeweils nachgeordneten Latentwärmespeichern besteht.

4. Elektrische Anlage nach Anspruch 1-3 **dadurch gekennzeichnet, dass** das Modul eine geschlossene oder offene Bauweise aufweist.

5. Elektrische Anlage nach Anspruch 4, **dadurch gekennzeichnet, dass** bei der offenen Bauweise das Modul am Ende des letzten Latentwärmespeichers ein weiteres abschließendes Peltierelement (10) aufweist.

6. Elektrische Anlage nach Anspruch 1-5, **dadurch gekennzeichnet, dass** als Peltierelemente Silizium-Peltiers oder Peltiers aus anderen Halbleiterwerkstoffen verwendet werden.

7. Elektrische Anlage nach Anspruch 1-6, **dadurch gekennzeichnet, dass** die Peltierelemente jeweils mit einem Latentwärmespeicher verbunden sind.

8. Elektrische Anlage nach Anspruch 1-7, **dadurch gekennzeichnet, dass** auf der Vorderseite der Zelle statt eines elektrisch leitenden Gitters eine transparent leitende Schicht aus Titanoxid oder Zinkoxid aufgebracht ist.

9. Elektrische Anlage nach Anspruch 1-8, **dadurch gekennzeichnet, dass** die Peltierelemente mit den benachbarten Bauteilen über eine Wärmeleitpaste oder andere leitende Verbindungen in Kontakt gebracht werden.

10. Elektrische Anlage nach Anspruch 1-9, **dadurch gekennzeichnet, dass** als Trägermaterial für die Latentwärmespeicher Gips, Zementgemische oder Kunststoffe verwendet werden, in deren Vernetzungsebenen die Latentwärmespeicher eingelagert sind.

11. Elektrische Anlage nach Anspruch 1-10, **dadurch gekennzeichnet, dass** die Latentwärmespeicher je nach benötigtem Latentwärmepunkt aus Ölen, Wassergemischen und/oder Salzen bestehen.

12. Elektrische Anlage nach Anspruch 3, **dadurch gekennzeichnet, dass** der erste Latentwärmespeicher mit dem angeschlossenen Peltierelement gegenüber dem zweiten Latentwärmespeicher unterschiedlich dimensioniert ist.

13. Elektrische Anlage nach Anspruch 1-12, **dadurch gekennzeichnet, dass** für die Peltierelemente mit den nachgeordneten Latentwärmespeichern eine äußere Beschaltung erfolgt.

14. Elektrische Anlage nach Anspruch 1-13, **dadurch gekennzeichnet, dass** als Isolationsschicht Polyurethanschäume, Inertgasverkapselungen oder Vakuumverkapselungen verwendet werden

## Claims

1. Electrical system with a layer of solar cells and a weather protective layer (1) located at the side facing the daylight, wherein on the back side of the layer of solar cells (3) a module of at least one peltier element (4, 7) and each with a downstream latent heat storage system, which are surrounded by a thermal insulation layer (5) is arranged and wherein the module is brought into contact with the layer of solar cells via a thermally conductive paste.

2. Electrical system according to claim 1, **characterized in that** the latent temperature value within the system is triggerd to the latent heat points each predetermined by the storage devices, so that a maximum amount of electricity can be generated and discharged.

3. Electrical system according to claims 1-2, **characterized in that** the module is composed of cascades of two or more peltier elements and each with downstream latent heat storage systems.

4. Electrical system according to claims 1-3, **characterized in that** the module comprises a closed or open construction.

5. Electrical system according to claim 4, **characterized in that** module with the open construction comprises a terminal peltier element at the end of the last latent heat storage system.

6. Electrical system according to claims 1-5, **characterized in that** silicon peltiers or peltiers made of other semiconductor materials are used as peltier elements.

7. Electrical system according to claims 1-6, **characterized in that** each of the peltier elements is connected with one latent heat storage system.

8. Electrical system according to claims 1-7, **characterized in that** the front side of the cell comprises a transparent conducting layer of titanium oxide or zinc oxide instead of an electric conducting grid.

9. Electrical system according to claims 1-8, **characterized in that** the peltier elements are brought into contact with neighboring components via a thermally conductive paste or other conductive connections.

10. Electrical system according to claims 1-9, **characterized in that** gypsum, cement mixtures or plastic components are used as carrier material for the latent heat storage systems, wherein the latent heat storage systems are placed in their meshwork levels.

11. Electrical system according to claims 1-10, **characterized in that** the latent heat storage systems are composed of oils, water mixtures and/or salts depending on the required latent heat point.

12. Electrical system according to claim 3, **characterized in that** the first latent heat storage system with the associated peltier element is dimensioned differently compared to the second latent heat storage system.

13. Electrical system according to claims 1-12, **characterized in that** an external circuit is used for the peltier elements with the downstream latent heat storage systems.

14. Electrical system according to claims 1-13, **characterized in that** polyurethane foams, inert gas encapsulations or vacuum encapsulations are used as insulation layer.

## Revendications

1. Installation électrique dotée d'une couche composée de cellules solaires et d'une couche de protection imperméable se trouvant sur un côté exposé à la lumière du jour (1),
un module composé d'au moins un élément à effet Peltier (4, 7) et d'un régulateur thermique à changement d'état respectif placé en aval (6, 9) entourés d'une couche d'isolation thermique (5), étant placé à l'arrière de la couche composée de cellules solaires (3) et le module étant mis en contact avec la couche composée de cellules solaires (3) par une pâte thermoconductrice.

2. Installation électrique conformément à la revendication n°1, **caractérisée par le fait que** la valeur thermique à changement d'état peut être commandée sur les points thermiques à changement d'état spécifiés par les fluides d'accumulation à l'intérieur de l'installation, de telle manière à ce qu'une quantité d'énergie électrique maximale puisse être générée et évacuée.

3. Installation électrique conformément aux revendications n°1 à n°2, **caractérisée par le fait que** le module se compose de cascades de deux éléments à effet Peltier ou plus et des régulateurs thermiques à changement d'état respectivement placés en aval.

4. Installation électrique conformément aux revendications n°1 à n°3, **caractérisée par le fait que** le module présente une construction fermée ou ouverte.

5. Installation électrique conformément à la revendication n°4, **caractérisée par le fait que**, dans le cas d'une construction ouverte, le module présente, à l'extrémité du dernier régulateur thermique à changement d'état, un autre élément à effet Peltier (10) terminal.

6. Installation électrique conformément aux revendications n°1 à n°5, **caractérisée par le fait que**, comme éléments à effet Peltier, des Peltiers de silicium ou des éléments à effet Peltiers constitués d'autres matériaux semi-conducteurs sont utilisés.

7. Installation électrique conformément aux revendications n°1 à n°6, **caractérisée par le fait que** chaque élément à effet Peltier est relié à un régulateur thermique à changement d'état.

8. Installation électrique conformément aux revendications n°1 à n°7, **caractérisée par le fait que**, à la place d'un treillis électroconducteur, une couche conductrice transparente composée d'oxyde de titane ou d'oxyde de zinc est placée sur la face avant de la cellule.

9. Installation électrique conformément aux revendications n°1 à n°8, **caractérisée par le fait que** les éléments à effet Peltier sont mis en contact avec les composants adjacents par une pâte thermoconductrice ou d'autres connexions conductrices.

10. Installation électrique conformément aux revendications n°1 à n°9, **caractérisée par le fait que**, comme matériau support pour les régulateurs thermiques à changement d'état, du plâtre, des mélanges de ciment ou des matières plastiques sont utilisés, les régulateurs thermiques à changement d'état étant stockés dans les niveaux de réticulation de ces matériaux supports.

11. Installation électrique conformément aux revendications n°1 à n°10, **caractérisée par le fait que** les régulateurs thermiques à changement d'état se composent, selon le point thermique à changement d'état requis, d'huiles, de mélanges d'eau et/ou de sels.

12. Installation électrique conformément à la revendication n°3, **caractérisée par le fait que** le premier régulateur thermique à changement d'état avec l'élément Peltier raccordé n'est pas dimensionné comme le deuxième régulateur thermique à changement d'état.

13. Installation électrique conformément aux revendications n°1 à n°12, **caractérisée par le fait que**, pour les éléments à effet Peltier avec les régulateurs thermiques à changement d'état placés en aval, la connexion est extérieure.

14. Installation électrique conformément aux revendications n°1 à n°13, **caractérisée par le fait que**, comme couche isolante, on utilise des mousses en polyuréthane, des encapsulations de gaz inerte ou sous vide.
